# EUROPÄISCHE PATENTANMELDUNG

(11) **EP 1 293 586 A2**
(43) Veröffentlichungstag der Anmeldung: **19.03.2003**
(21) Anmeldenummer: 02018973.4
(22) Anmeldetag: 26.08.2002
(51) Int. Cl.: C23C 14/35, C23C 14/50, H01J 37/34

(54) **Einrichtung zum Beschichten von Substraten mit gekrümmter Oberfläche durch Pulsmagnetron-Zerstäuben**

(30) Priorität: 13.09.2001 DE 10145050
(71) Anmelder: Fraunhofer-Gesellschaft zur Förderung der angewandten Forschung e.V., 80636 München (DE)
(72) Erfinder: Liebig, Jörn-Steffen, 01328 Dresden, OT Malschendorf (DE); Goedicke, Klaus, 01307 Dresden (DE); Kirchhoff, Volker, 01324 Dresden (DE)

(57) **Zusammenfassung**

Die Erfindung betrifft eine Einrichtung zum Beschichten von Substraten (3) mit gekrümmter Oberfläche mittels Pulsmagnetron-Zerstäuben, enthaltend in einer evakuierbaren Beschichtungskammer mindestens ein Paar rechteckiger Magnetronquellen (1; 2) und Substrathalterungen, durch die Substrate (3) während der Beschichtung relativ zu den Magnetronquellen linear bewegt werden können, wobei die Magnetronquellen (1; 2) ebene rechteckförmige Targets besitzen, deren Verhältnis von Länge zu Breite mindestens 2:1 beträgt, die Magnetronquellen
(1; 2) längs zur Transportrichtung der Substrate (3) angeordnet sind, die Targetmitten einen Abstand (4) zueinander haben, der mindestens der Substratausdehnung quer zur Transportrichtung entspricht, der kürzeste Abstand (5; 6) jedes Targets zur Oberfläche der Substrate (3) ebenfalls mindestens der Substratausdehnung quer zur Transportrichtung entspricht und die Flächennormalen auf den Mittellinien der Targetflächen zumindest zeitweise jeweils etwa auf den nächstgelegenen Substratrand ausgerichtet sind.

## Beschreibung

Die Erfindung betrifft eine Einrichtung zum Beschichten von Substraten mit gekrümmter Oberfläche mittels Pulsmagnetron-Zerstäuben, in welcher die Substrate während der Beschichtung relativ zu den Magnetronquellen linear bewegt werden können. Solche Einrichtungen finden Anwendung beim Aufbringen dünner Schichten auf Werkstücke und Formteile, beispielsweise bei dem Beschichten optischer Linsen, Reflektoren oder geformter Automobilscheiben mit transparenten optischen Funktionsschichten.

Das Pulsmagnetron-Zerstäuben als Beschichtungsverfahren kommt häufig zum Einsatz, wenn bestimmte Schichteigenschaften durch andere Beschichtungsverfahren nicht oder nur wesentlich unwirtschaftlicher erzielt werden können.
Es ist allgemein bekannt, Substrate mit gekrümmter Oberfläche mittels Magnetron-Zerstäuben zu beschichten, wobei die meist kleinformatigen Substrate auf einem Drehkorb oder einer Halterung mit planetenartiger Bewegung relativ zu den Magnetronquellen bewegt werden. Im Allgemeinen wird nur eine geringe Gleichmäßigkeit der Schichtdicke erreicht.
Aus DE 295 05 497 U1 ist eine Einrichtung zur Verbesserung der Gleichmäßigkeit bei der Beschichtung gekrümmter Oberflächen mit einer flächigen Magnetronquelle in planetenartig bewegten Halterungen bekannt. Nachteilig ist, dass sich diese Einrichtung nicht in Beschichtungsanlagen mit linearem Substratfluss verwenden lässt.
Es ist weiterhin bekannt, ebene Substrate ohne Substratbewegung mittels zweier Magnetronquellen, die gegeneinander geneigt sind, zu beschichten (DE 40 10 495 C2, US 4,692,230). Solche Einrichtungen eignen sich z. B. zum gleichzeitigen Beschichten dieser ebenen Substrate mit zwei unterschiedlichen Materialien, dem sogenannten Ko-Zerstäuben. Die Gleichmäßigkeit der Beschichtung ist jedoch auch in derartigen Einrichtungen oft unzureichend.
Für die Beschichtung stationärer Substrate mit gekrümmter Oberfläche wird gemäß DE 198 13 075 A1 / EP 0 945 524 A1 eine Magnetron-Beschichtungseinrichtung mit einem mehrteiligen Target vorgeschlagen, bei der der Abstand der Teiltargets relativ zum Substrat je nach der Krümmung des Substrates eingestellt werden kann. Auch diese Lösung ist nicht auf einen linearen Fluss von Substraten relativ zu den Magnetronquellen anwendbar. Sie ist darüber hinaus auf Substrate mit rotationssymmetrischer, z. B. sphärisch gekrümmter Oberfläche beschränkt.

Häufig werden linear bewegte Substrate mit schwach gekrümmten Oberflächen mittels Magnetronquellen beschichtet, wobei die Quellen parallel zur Bewegungsebene der Substrate positioniert sind und durch Ausblenden eines Teils des Stromes abgestäubter Teilchen eine Verbesserung der Schichtgleichmäßigkeit angestrebt wird. Solche Dampfblenden verschlechtern die Effizienz des Beschichtungsprozesses und die Stabilität des Prozesses infolge von Störwirkungen von Schichten, die zwangsläufig auf den Blenden aufwachsen. Insbesondere besteht die Gefahr des Abplatzens solcher Schichten von den Blenden bereits nach kurzer Betriebszeit. Dieser Nachteil ist besonders gravierend, wenn transparente, nichtleitende Verbindungen ― wie sie z. B. als hoch- und niederbrechende optische Schichten zum Einsatz kommen ― abgeschieden werden sollen. Außerdem ist durch die Verringerung der Effizienz ein häufigerer Wechsel der teuren Targets nötig.

Die Verwendung von Dual-Magnetron-Systemen, die vorzugsweise mit gepulster Elektroenergie gespeist werden, ermöglicht prinzipiell die langzeitstabile Abscheidung auch von transparenten, nichtleitenden Verbindungen, weshalb derartige Systeme heute weit verbreitet sind. Die nachteiligen Wirkungen parasitärer Beschichtungen auf Blenden und ähnlichen Baugruppen und die damit verbundene Ausblendung eines Teiles des Materialstromes beieinträchtigen jedoch auch die Effizienz und Gleichmäßigkeit von Beschichtungen, die mit Hilfe von Dual-Magnetron-Systemen aufgetragen werden.

Die Aufgabe der vorliegenden Erfindung ist die Schaffung einer Einrichtung zum Beschichten von Substraten mit gekrümmter Oberfläche mittels Pulsmagnetron-Zerstäuben, die unter Vermeidung der Nachteile des Standes der Technik bei einem linearen Substratfluss zu Beschichtungen mit gegenüber dem Stand der Technik erhöhter Gleichmäßigkeit der Schichtdicke führt und eine bessere Ausnutzung der Targets ermöglicht.

Die Aufgabe wird durch eine Einrichtung mit Merkmalen des Anspruchs 1 gelöst. Die Ansprüche 2 bis 13 beschreiben zweckmäßige Ausgestaltungen der erfindungsgemäßen Einrichtung.

Eine Beschichtungsanlage enthält neben bekannten Vakuumerzeugungsmitteln mechanische Vorrichtungen, die einen linearen Transport gekrümmter Substrate ermöglichen. Die Einrichtung enthält außerdem Magnetronquellen mit ebenen rechteckförmigen Targets, die paarweise angeordnet und mit ihrer zerstäubenden Fläche auf die gekrümmten Substrate gerichtet sind. Die Ausrichtung der Flächennormalen auf der Mittellinie der Targetflächen erfolgt so, dass sie während der Beschichtung zumindest zeitweise etwa auf den jeweils nächstgelegenen Randbereich der gekrümmten Substrate weist. Die Einrichtung kann weiterhin Mittel zur Durchführung eines reaktiven Zerstäubungsvorganges enthalten. Diese umfassen in erster Linie die Gaseinlässe für Reaktivgase und bekannte Baugruppen zur Prozessregelung. Die Magnetronquellen sind derart angeordnet, dass die langen Seiten der rechteckigen Targets parallel zur Bewegungsrichtung der Substrate ausgerichtet sind. Die Targets weisen ein Seitenverhältnis von Länge zu Breite von mindestens 2:1, vorzugsweise von 3:1 auf. Sowohl der Abstand der Targetmitten eines Paares von Magnetronquellen als auch der kürzeste Abstand zwischen den Targetmitten und der Substratoberfläche ist mindestens so groß wie die Ausdehnung der Substrate quer zu ihrer Bewegungsrichtung, im Allgemeinen jedoch größer. Beide geometrischen Größen hängen im Übrigen von der Größe und dem Krümmungsradius der Substrate sowie von der Breite der Targets der Magnetronquellen ab und lassen sich deshalb nicht in allgemeiner Form angeben. Ihre Bestimmung erfolgt gegebenenfalls durch schrittweise Optimierung durch Beschichtung und Auswertung der erreichten Schichtdickenverteilung. Als besonders vorteilhaft hat sich erwiesen, wenn der Abstand zwischen den Targetmitten größer ist, als die Ausdehnung der Substrate quer zu ihrer Transportrichtung, wobei die Flächennormalen auf der Mittellinie der Targetflächen ständig oder zumindest zeitweise jeweils etwa auf den nächstgelegenen Substratrand ausgerichtet sind. In bestimmten Fällen, z. B. wenn der Krümmungsradius quer zur Bewegungsrichtung nicht konstant ist, kann es zusätzlich erforderlich sein, durch eine Aperturblende eine Korrektur des Stromes der zerstäubten Teilchen vorzunehmen. Diese Ausblendung ist jedoch größenordnungsmäßig geringer als eine solche, die bei Verwendung von Einrichtungen nach dem Stand der Technik erforderlich ist.
Das erfindungsgemäße Verhältnis von Länge zu Breite der rechteckförmigen Targets der Magnetronquellen einerseits und die erfindungsgemäße Ausrichtung auf die Randbereiche der linear bewegten Substrate andererseits bewirken offenbar eine Quelldichteverteilung der abgestäubten Teilchen, die den Erfordernissen einer homogenen Beschichtung der gekrümmten Substrate optimal gerecht werden. Die wesentlichen Beiträge zum Dampfstrom werden in den geraden, der Bewegungsrichtung der Substrate parallelen Bereichen der Emissionszonen auf den beiden Targets der paarweise angeordneten Magnetronquellen zerstäubt. Der Neigungswinkel beider Targets des Paares sowie deren Abstand bewirken durch Superposition besagter Dampfströme die bestmögliche Schichtdickengleichmäßigkeit.

Besonders vorteilhaft für die Beschichtung rotationssymmetrisch gekrümmter Substrate, also beispielsweise sphärischer Linsen, ist es, die Substrate so zu führen, dass sie eine zusätzliche Rotationsbewegung um eine Körperachse vollführen. Besonders vorteilhaft ist dabei die Eigenrotation um eine Achse, welche senkrecht zur Transportebene durch die jeweilige Substratmitte verläuft. Durch eine solche Rotationsbewegung werden Unterschiede in der Schichtdickengleichmäßigkeit längs und quer zur Transportrichtung der Substrate ausgeglichen.

Bei der Beschichtung von Substraten, die zwei deutlich voneinander abweichende Krümmungsradien längs und quer zur Hauptbewegungsrichtung der Substrate aufweisen, wie z. B. bei der Beschichtung von Windschutzscheiben für PKW, ist es besonders vorteilhaft, wenn die Substrate während ihres Transportes durch die Beschichtungszone eine zusätzliche Taumelbewegung ausführen. Die Substrate werden auf entsprechenden Halterungen linear durch die Zerstäubungsanlage bewegt. Die Halterungen sind in einer Weise beweglich angeordnet, dass das Substrat beispielsweise in Bewegungsrichtung mit einem positiven Neigungswinkel gegen die Senkrechte in die Beschichtungszone eintritt und die Beschichtungszone mit einem negativen Neigungswinkel verlässt. Besonders vorteilhaft ist dabei, wenn die Substratachse mit der größten Krümmung der Bewegungsrichtung parallel ist.

Eine weitere zweckmäßige Ausgestaltung der Erfindung ist dadurch gekennzeichnet, dass die Position der Magnetronquellen und/oder ihre Ausrichtung auf den Randbereich der Substrate nach einem vorgegebenen Programm veränderbar ist. Dazu sind bewegliche und kippbare Halterungen für die Magnetronquellen, vorzugsweise rechnergesteuerte mehrachsige Antriebe, wie sie aus dem Werkzeugmaschinenbau bekannt sind, enthalten.
Es kann weiterhin vorteilhaft sein, wenn die Einrichtung mit elektrischen Baugruppen ausgerüstet ist, welche die Energie zum Betreiben der Magnetronquellen in Form unipolarer Pulse mit einer vorzugsweise einstell- oder regelbaren Frequenz im Bereich von 10 bis 100 kHz einspeisen. Damit lassen sich Schichteigenschaften, z. B. die Dichte der Schicht oder andere physikalisch-technische Eigenschaften in gewünschtem Sinne beeinflussen.
Es kann auch zweckmäßig sein, die Einrichtung mit elektrischen Baugruppen auszurüsten, die eine bipolare pulsförmige Energieeinspeisung im Frequenzbereich von 10 bis 100 kHz ermöglichen. Diese Ausgestaltung ist besonders vorteilhaft, wenn elektrisch isolierende Schichten mit hoher Abscheiderate auf den Substraten abgeschieden werden sollen.

Schließlich kann es zweckmäßig sein, die Einrichtung mit Umschalteinrichtungen auszustatten, die eine wahlfreie Speisung der Magnetronquellen mit unipolaren oder bipolaren Pulsen mit einer einstell- oder regelbaren Frequenz im Bereich von 10 bis 100 kHz zulassen. Die Form der Energieeinspeisung steht dann als frei wählbarer Parameter zur Verbesserung von Schichteigenschaften zur Verfügung, z. B. für die Minimierung innerer Spannungen in den abgeschiedenen Schichten. Insbesondere bei der Abscheidung von spannungsarmen Oxidschichten auf organischen Substraten können durch Wahl optimaler Pulsparameter für die in die Magnetronquellen eingespeiste Energie Arbeitsdruck und Abstand zwischen Substrat und Magnetronquellen so gewählt werden, dass sich mit der erfindungsgemäßen Einrichtung bei hoher Schichtdickengleichmäßigkeit eine sehr gute Targetausnutzung realisieren lässt, da sich gegenüber dem Stand der Technik (EP 0 947 601 A1) eine wesentliche Verbesserung der Ausnutzung des Stromes zerstäubter Teilchen ergibt. All diese Mittel können ebenfalls erfolgreich bei der Beschichtung von Substraten angewendet werden, deren Krümmungsradien sich längs und/oder quer zur Transportrichtung der Substrate ändern. Sie dienen in erster Linie zur Einstellung von Schichteigenschaften wie Dichte, Härte oder innerer Spannung, die für viele Materialien in einem gewissen Bereich durch Variation der Energieeinspeisung und der Pulsparameter beeinflusst werden können.

In einem Ausführungsbeispiel wird eine vorteilhafte Ausgestaltung der Einrichtung näher erläutert.

Dabei zeigt die zugehörige Abbildung den Querschnitt einer erfindungsgemäßen Beschichtungsanordnung senkrecht zur Transportrichtung der Substrate.
Die Einrichtung dient der einseitigen Beschichtung von Linsen mit rotationssymmetrisch gekrümmten Oberflächen.

Innerhalb einer evakuierbaren Beschichtungskammer sind zwei rechteckige Magnetronquellen 1; 2 angeordnet. Die Abmessungen der Targets der Magnetronquellen betragen 80 x 300 mm². Den Magnetronquellen 1; 2 gegenüber befinden sich auf drehbaren und in Transportrichtung linear bewegbaren Substrathaltern (hier nicht dargestellt) Substrate 3 mit rotationssymmetrisch konvex gekrümmten Oberflächen. Die rechteckigen Magnetronquellen 1; 2 sind so ausgerichtet, dass ihre Längsseiten parallel zur Transportrichtung der Substrate verlaufen. Die weiteren Positionsparameter der rechteckigen Magnetronquellen 1; 2 werden in Abhängigkeit von Durchmesser und Krümmungsradius der zu beschichtenden Substrate 3 festgelegt. Der Substratdurchmesser im vorliegenden Beispiel beträgt 70 mm, der Krümmungsradius der konvexen Oberfläche beträgt 130 mm. Der Abstand 4 zwischen den Mittellinien der Targetflächen beträgt 130 mm und die Abstände 5; 6 von den Mittellinien der Targetflächen zum jeweils nächstgelegenen Substratrand betragen 85 mm. Die Targetflächen sind etwa in Richtung Substratrand ausgerichtet. Ihre Flächennormalen stehen im Winkel von 30° zueinander.
Die Schichtdicke nimmt hierbei ohne Rotation der Substrate um ihre Symmetrieachse am Rand bis auf maximal 93 % des Maximums ab. Mit einer zusätzlichen Rotation der Substrate um die Symmetrieachse lässt sich die maximale Abweichung der Schichtdicke am Rand auf 3 % reduzieren, d. h. die Schichtdicke beträgt überall auf dem Substrat mindestens 97 % des Maximums.
In beiden Fällen kommen keine Korrekturblenden zum Einsatz. Die Effizienz des Beschichtungsprozesses erlaubt eine 20 % längere Gebrauchsdauer der Targets im Vergleich zu planaren Beschichtungsanordnungen.
Die beiden Magnetronquellen 1; 2 werden von einer geeigneten Energieversorgung 7 entweder mit bipolaren oder unipolaren Pulsen gespeist. Die Wahl der Energie- und Pulsparameter hängt von dem Material der zu beschichtenden Linsen und von den erforderlichen Eigenschaften der abgeschiedenen Schichten ab.
Im vorliegenden Fall wird von metallischen Silizium-Targets in einem geregelten reaktiven Sputterprozess durch Hinzugabe von Sauerstoff in den Beschichtungsraum transparentes Siliziumoxid abgeschieden. Die Magnetronquellen 1; 2 werden mit sinusförmigen Energiepulsen bipolar mit einer elektrischen Leistung von 4 kW gespeist.

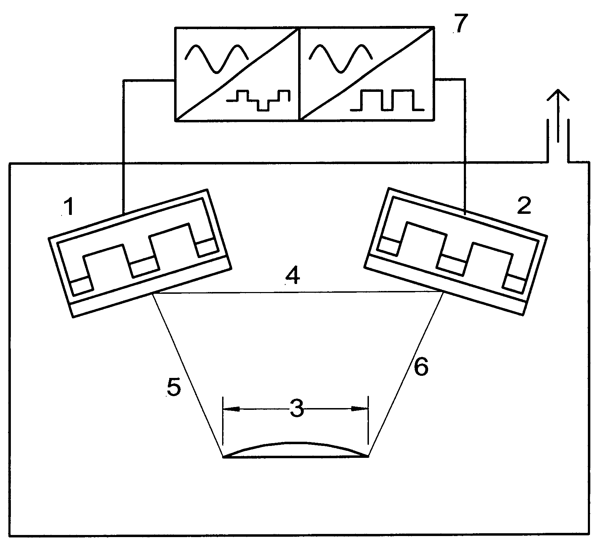

## Patentansprüche

1. Einrichtung zum Beschichten von Substraten (3) mit gekrümmter Oberfläche mittels Pulsmagnetron-Zerstäuben, enthaltend in einer evakuierbaren Beschichtungskammer mindestens ein Paar rechteckiger Magnetronquellen (1; 2) und Substrathalterungen, durch die Substrate (3) während der Beschichtung relativ zu den Magnetronquellen linear bewegt werden können, **dadurch gekennzeichnet,**
**dass** die Magnetronquellen (1; 2) ebene rechteckförmige Targets besitzen, deren Verhältnis von Länge zu Breite mindestens 2:1 beträgt,
**dass** die Magnetronquellen (1; 2) längs zur Transportrichtung der Substrate (3) angeordnet sind,
**dass** die Targetmitten einen Abstand (4) zueinander haben, der mindestens der Substratausdehnung quer zur Transportrichtung entspricht,
**dass** der kürzeste Abstand (5; 6) jedes Targets zur Oberfläche der Substrate (3) ebenfalls mindestens der Substratausdehnung quer zur Transportrichtung entspricht und
**dass** die Flächennormalen auf den Mittellinien der Targetflächen zumindest zeitweise jeweils etwa auf den nächstgelegenen Substratrand ausgerichtet sind.

2. Einrichtung nach Anspruch 1, **dadurch gekennzeichnet, dass** der Abstand zwischen den Targetmitten größer ist als die Ausdehnung der Substrate quer zu ihrer Transportrichtung.

3. Einrichtung nach Anspruch 1 oder 2, **dadurch gekennzeichnet, dass** die Magnetronquellen ebene rechteckförmige Targets besitzen, deren Verhältnis von Länge zu Breite mindestens 3:1 beträgt.

4. Einrichtung nach mindestens einem der Ansprüche 1 bis 3, **dadurch gekennzeichnet, dass** die Magnetronquellen so montiert sind, dass sich ihre Ausrichtung während der Beschichtung nicht verändert.

5. Einrichtung nach mindestens einem der Ansprüche 1 bis 3, **dadurch gekennzeichnet, dass** die Magnetronquellen so montiert sind, dass sich ihre Ausrichtung und/oder Position während der Beschichtung verändern lässt.

6. Einrichtung nach Anspruch 5, **dadurch gekennzeichnet, dass** Mittel vorhanden sind, die eine automatische Veränderung der Ausrichtung und/oder Position der Magnetronquellen während der Beschichtung nach einem vorgegebenen Programm ermöglichen.

7. Einrichtung nach mindestens einem der Ansprüche 1 bis 6, **dadurch gekennzeichnet, dass** die Substrathalterungen so ausgeführt sind, dass die Substrate in der Beschichtungskammer zusätzlich eine Rotationsbewegung um eine Körperachse, die senkrecht zur Linearbewegung ist, ausführen können.

8. Einrichtung nach mindestens einem der Ansprüche 1 bis 6, **dadurch gekennzeichnet, dass** die Substrathalterungen so ausgeführt sind, dass die Substrate in der Beschichtungskammer zusätzlich eine taumelnde Bewegung ausführen können.

9. Einrichtung nach mindestens einem der Ansprüche 1 bis 8, **dadurch gekennzeichnet, dass** Reaktivgaseinlässe enthalten sind.

10. Einrichtung nach mindestens einem der Ansprüche 1 bis 9, **dadurch gekennzeichnet, dass** Regelungstechnik zur Prozessführung beim reaktiven Pulsmagnetron-Zerstäuben enthalten ist.

11. Einrichtung nach mindestens einem der Ansprüche 1 bis 10, **dadurch gekennzeichnet, dass** die Energie in die Magnetronquellen in Form unipolarer Pulse mit einer Frequenz im Bereich von 10 bis 100 kHz einspeisbar ist.

12. Einrichtung nach mindestens einem der Ansprüche 1 bis 10, **dadurch gekennzeichnet, dass** die Energie in die Magnetronquellen in Form bipolarer Pulse mit einer Frequenz im Bereich von 10 bis 100 kHz einspeisbar ist.

13. Einrichtung nach mindestens einem der Ansprüche 1 bis 12, **dadurch gekennzeichnet, dass** durch einen Schalter wahlfrei die Energie in die Magnetronquellen in Form bipolarer oder unipolarer Pulse einspeisbar ist.
